# EUROPÄISCHE PATENTSCHRIFT

(11) **EP 2 223 128 B1**
(45) Veröffentlichungstag und Bekanntmachung des Hinweises auf die Patenterteilung: **05.06.2019**
(21) Anmeldenummer: 08864298.8
(22) Anmeldetag: 18.12.2008
(51) Int. Cl.: G01R 15/20, G01R 33/022, G01R 33/09

(54) **ANORDNUNG ZUM POTENTIALFREIEN MESSEN VON STRÖMEN**
ARRANGEMENT FOR THE POTENTIAL-FREE MEASUREMENT OF CURRENTS
DISPOSITIF DE MESURE DE COURANTS EXEMPTE DE POTENTIEL

(30) Priorität: 22.12.2007 DE 102007062633
(43) Veröffentlichungstag der Anmeldung: 01.09.2010
(73) Patentinhaber: Sensitec GmbH, 36633 Lahnau (DE)
(72) Erfinder: SCHMITT, Jochen, 35216 Biedenkopf (DE)
(74) Vertreter: Spachmann, Holger
(86) Internationale Anmeldenummer: PCT/EP2008/010833
(87) Internationale Veröffentlichungsnummer: WO 2009/080286

(56) Entgegenhaltungen:
- EP-A- 0 874 244
- EP-A- 1 746 426
- WO-A-00/11482
- WO-A-02/06844
- DE-U1- 20 017 512
- US-B1- 6 184 679

## Beschreibung

Die Erfindung betrifft eine Anordnung zum potentialfreien Messen von Strömen nach dem Oberbegriff des Anspruchs 1.

Derartige bekannte Anordnungen messen Ströme durch Erfassen eines magnetischen Differenzfelds bzw. Magnetfeldgradienten, der durch einen Strom durch eine im Wesentlichen U-förmige Leitereinheit erzeugt wird, deren Schenkel als Primärleiter bezeichnet werden können (WO 00/11482, DE 4300605 C2, US 5548208).

Das magnetische Differenzfeld bzw. der Magnetfeldgradient durchsetzt einen Differenzfeldsensor bzw. ein Gradiometer, der bzw. das eine dem magnetischen Differenzfeld bzw. Magnetfeldgradienten entsprechende Signalspannung erzeugt, ohne mit dem Primärstromkreis galvanisch verbunden zu sein. Damit wird ein Messsystem ohne aufwendige magnetische Flussführung angestrebt, in dem der Einfluss von magnetischen Störfeldern gleichwohl minimiert ist.

Als geeignete Differenzfeldsensoren können insbesondere Sensoren auf der Basis magnetoresistiver Effekte wie des anisotropen magnetoresistiven Effekts (AMR) oder des gigantischen magnetoresistiven Effekts (GMR) dienen. Denkbar sind auch derartige Sensorsysteme auf der Grundlage des kolossalen magnetoresistiven Effekts (CMR) oder des tunnelmagnetoresistiven Effekts (TMR).

Bei Anordnungen zum potentialfreien Messen von Strömen der eingangs genannten Gattung wird, wie oben erwähnt, angestrebt, eine Empfindlichkeit gegenüber äußeren magnetischen Störfeldern, welche die Erfassung des für die Messung relevanten magnetischen Differenzfelds bzw. Feldgradienten stören können, herabzusetzen. Die äußeren magnetischen Felder können u.a. durch Wirbelströme hervorgerufen werden, die ihrerseits von dem Magnetfeld des zu messenden Stroms, der als Primärstrom bezeichnet wird, in benachbarten Metallteilen induziert werden. Um die dadurch verursachten frequenzabhängigen Messfehler herabzusetzen, ist es bereits bekannt, in einer Anordnung des eingangs genannten Gattung die Querschnittsfläche und -form sowie die Materialauswahl der Primärleiter und ihren Abstand von gegebenenfalls speziell geformten benachbarten Metallteilen und den verwendeten magnetfeldempfindlichen Messgeräten, insbesondere Sensoren, so abzustimmen, dass sich die Einflüsse verschiedener elektrodynamischer Effekte, insbesondere der Induktion von Wirbelströmen in den benachbarten Metallteilen, gegenseitig weitgehend kompensieren (DE 1 981 94 70 A1 , insbesondere Fig. 4). Im Einzelnen ist eine solche Anordnung mit einer U-förmig ausgeführten Leitereinheit realisiert, auf der eine dielektrische Platte befestigt ist, die ein Magnetfeldmessgerät trägt und eine galvanische Trennung herbeiführt. Oberhalb und unterhalb dieser Anordnung befinden sich die oben erwähnten benachbarten Metallteile, insbesondere Platten, in vorbestimmtem Abstand.

Aus der EP-A-0 874 244 ist bereits eine Vorrichtung zum potentialfreien Messen von elektrischen Strömen bekannt, die in zwei im Wesentlichen parallel angeordneten Stromleitern in zueinander entgegengesetzter Richtung fließen, durch Erfassen des magnetischen Differenzfelds mittels eines Sensorchips, wobei die Stromleiter innerhalb eines Ferritkerns, welcher im Querschnitt im Wesentlichen E-förmig ausgebildet ist, angeordnet sind. Der Ferritkern befindet sich auf einer Seite eines platinenförmigen Isolators, auf dessen gegenüberliegender Seite der Sensorchip angeordnet ist. Der Ferritkern dient neben seiner Funktion als Flusskonzentrator, der den von den Stromleitern erzeugten magnetischen Fluss auf den Sensorchip konzentriert, in erster Linie zur Entkopplung von Feldstärke und -verlauf von der Leitergeometrie. Außerdem kann er u.a. zur Abschirmung gegenüber äußeren magnetischen Feldern auf einer Seite des Sensorchips dienen. Der Sensorchip ist dadurch aber nicht für alle Anwendungen ausreichend gegen äußere magnetische Felder geschützt, die den magnetischen Feldgradienten im Bereich des Sensorchips direkt störend beeinflussen können. Ferner bekannt ist aus der DE 200 17 512 U1 eine Einrichtung zum Messen von Strom auf einer Leiterplatte, auf der ein U-förmiger Stromleiter mit einem Hinleiter und einem Rückleiter angeordnet ist. Oberhalb des Stromleiters ist ein Magnetfeldsensor angeordnet. Die Anordnung aus Magnetfeldsensor und dem Hinleiter sowie Rückleiter ist zumindest oberseitig und unterseitig von Platten aus ferritischem Material überdeckt. Besonders bevorzugt ist die vorgenannte Anordnung allseitig von Platten aus ferritischem Material überdeckt, d.h. auch an allen vier Seitenflächen des von den Platten umgrenzten Raums, so dass die Anordnung gehäuseförmig umschlossen ist. Obwohl damit das Eindringen eines störenden äußeren Magnetfelds in den Bereich des Magnetfeldsensors weitgehend, bei gehäuseförmiger Anordnung der Platten aus ferritischem Material sogar praktisch vollständig vermieden werden soll, hat sich gezeigt, dass äußere Magnetfelder immer noch die Erfassung bzw. Messung des durch den Hinleiter und den Rückleiter fließenden Stroms störend beeinflussen können.

Aufgabe der vorliegenden Erfindung ist es, in einer Anordnung zum potentialfreien Messen von Strömen der eingangs genannten Gattung den Einfluss äußerer Störfelder auf die Erfassung des magnetischen Differenzfelds bzw. Feldgradienten von zwei im Wesentlichen parallelen Primärleitern in technisch wenig aufwendiger Weise noch weiter herabzusetzen und mit den hierzu einzusetzenden Mitteln einen technischen Zusatznutzen zu erzielen.

Diese Aufgabe wird durch die in Anspruch 1 angegebenen Merkmale gelöst.

Durch die erfindungsgemäß ausgebildeten beiden Metallteile als Abschirmbleche aus hochpermeablem Material, von denen wenigstens eines in Querschnittsebenen U-förmig mit jeweils einem Paar Schenkeln ausgebildet sind, die sich in einer Längsrichtung rechtwinklig zu den U-förmigen Querschnittsebenen erstrecken, wobei die beiden Abschirmbleche so zueinander angeordnet sind, dass das wenigstens eine Schenkelpaar eines der beiden Abschirmbleche unter Freilassung je eines Luftspalts an einem der beiden Schenkel auf das andere der beiden Abschirmbleche ausgerichtet ist, und wobei sich die Primärleiter in Längsrichtung der Schenkel erstrecken, wird eine sehr gute Abschirmung des Differenzfeldsensors, der sich wie die Primärleiter innerhalb des von den Abschirmblechen eingeschlossenen Raums befindet, gegen äußere magnetische Störfelder erzielt. Bei wie oben angegeben positionierten Schenkeln der Abschirmbleche aus hochpermeablem Material entsteht durch äußere homogene oder inhomogene Magnetfelder praktisch kein Magnetfeldgradient in der wirksamen Sensorebene, und zwar weitgehend unabhängig von der Einwirkungsrichtung der Störfelder von außen auf die beiden Abschirmbleche. Dies bedeutet auch, dass ein inhomogenes Magnetfeld, welches von einem Leiter ausgeht, der außerhalb zu der Anordnung der beiden Abschirmbleche zu diesen benachbart ist, sich nicht störend auf den Differenzfeldsensor innerhalb der Abschirmblechanordnung auswirkt. Trotzdem werden die von den Primärleitern ausgehenden magnetischen Feldgradienten, die von dem Differenzfeldsensor erfasst werden, nicht sehr abgeschwächt, da die beiden Abschirmbleche keinen vollständig geschlossenen Magnetkreis um die Primärleiter bilden. Die Dimensionierung der Abschirmbleche, die entsprechend den Merkmalen des Anspruchs ausgebildet und angeordnet sind, können durch einfache Versuche bzw. Simulationsrechnungen des Feldverlaufs, insbesondere an der Stelle des Differenzfeldsensors, ermittelt werden.

Hiermit kann weiterhin als Zusatznutzen die Messempfindlichkeit bzw. der Messbereich der Anordnung zum potentialfreien Messen von Strömen eingestellt werden, und zwar durch Variation der Luftspalte und/oder der Abmessungen, insbesondere der Dicke der Abschirmbleche.

In einer wirkungsvollen Variante der erfindungsgemäßen Anordnung sind beide Abschirmbleche mit jeweils einem Paar Schenkel geformt, zwischen denen sich jeweils einer der Stege befindet, und diese beiden Abschirmbleche sind so zueinander angeordnet, dass die beiden Schenkelpaare der Abschirmbleche unter Freilassung je eines Luftspalts zwischen zwei der Schenkel aufeinander ausgerichtet sind.

Mit der erfindungsgemäßen Anordnung und deren Variante kann die Messaufgabe gelöst werden, einen Strom durch eine U-förmige Leitereinheit gemäß Anspruch 8 zu messen, der in zwei parallelen Schenkeln der U-förmigen Leitereinheit, die Primärleiter darstellen, in entgegen gesetzter Richtung fließt. Insbesondere eignet sich die Anordnung zur Messung großer Ströme, beispielsweise in einem Strommessbereich von 2000 A, wobei die Messung durch magnetische Störfelder, die ansonsten bei hohen Primärströmen entstehen, nicht verfälscht wird.

Es kann aber auch eine zweite Messaufgabe gemäß Anspruch 9 erfüllt werden, bei der eine Differenz von zwei Strömen in zwei Primärleitern zu messen ist, die ein Hinleiter und ein Rückleiter eines elektrischen Verbrauchers sind, um eventuelle Fehlerströme in dem Verbraucher - einem Gerät oder Aufbau - zu detektieren. Bei der letztgenannten Messaufgabe ist eine Abschirmung externer magnetischer Störfelder besonders geboten, da der magnetische Feldgradient, der aus den Primärströmen in dem Hin- und Rückleiter resultiert, gering ist.

Bei beiden oben genannten Konfigurationen der Primärleiter sind diese gemäß Anspruch 3 zwischen den Schenkeln eines der beiden Abschirmbleche angeordnet, woraus eine kompakte Ausbildung der gesamte Messanordnung mit dem Differenzfeldsensor resultiert, dessen wirksame Sensorebene bevorzugt gemäß Anspruch 4 außerhalb der Schenkel des Abschirmblechs liegt, zwischen denen die Primärleiter angeordnet sind. Damit kann auch eine hohe Messempfindlichkeit erzielt werden, ohne das von dem Differenzfeldsensor erfasste magnetische Differenzfeld bzw. den Feldgradienten erheblich zu schwächen.

In einer Grundanordnung zum potentialfreien Messen von Strömen gemäß Anspruch 5 sind die Schenkel der beiden Abschirmbleche gleich lang und die beiden Abschirmbleche sind symmetrisch zu einer wirksamen Sensorebene angeordnet.

Die wirksame Sensorebene ist die Ebene des Differenzfeldsensors, in der die Umwandlung des Differenzfelds bzw. magnetischen Feldgradienten in eine Signalspannung erfolgt, also z.B. die magnetoresistive Schicht und nicht das Substrat bzw. der Träger des Sensors.

In einer modifizierten und platzoptimierten Gesamtanordnung gemäß Anspruch 6 sind zwar auch die Schenkel jeweils eines der Abschirmbleche gleich lang, die Schenkelpaare der Abschirmbleche weisen jedoch unterschiedliche Länge auf, so dass das eine Abschirmblech zwei gleich lange kürzere Schenkel hat und das andere Abschirmblech zwei gleich lange längere Schenkel. Die Primärleiter sind zwischen den längeren Schenkeln des entsprechenden Abschirmblechs angeordnet. Dies bedeutet, dass die Luftspalte unsymmetrisch zu einer Mittelebene angeordnet sind, die in der Mitte der Anordnung der beiden Abschirmbleche parallel zu deren Stegen liegt. Desgleichen ist die wirksame Sensorebene gegenüber der genannten Mittelebene verschoben. Die Stege sind vorzugsweise plane Abschnitte der Abschirmbleche, welche an ihnen rechtwinklig abgebogene Schenkel verbinden.

Sowohl bei der Grundanordnung als auch bei der modifizierten Anordnung erstrecken sich die Abschirmbleche in Längsrichtung ihrer Schenkel über den Differenzfeldsensor, um diesen gegenüber äußeren magnetischen Störfeldern wirksam abzuschirmen. Die Längsrichtung der Schenkel der Abschirmbleche verläuft parallel zu der Stromrichtung in den Primärleitern.

In dem Fall, in dem die beiden Primärleiter Bestandteile einer U-förmigen Leitereinheit sind, erstrecken sich die Abschirmbleche gemäß Anspruch 10 zur guten Abschirmung des Differenzfeldsensors gegenüber externen magnetischen Störfeldern zweckmäßig in Längsrichtung ihrer Schenkel über die Länge der Schenkel der U-förmigen Leitereinheit.

Die Abschirmbleche aus hochpermeablem Material können typisch aus Mu-Metall gemäß Anspruch 11 bestehen oder Elektrobleche gemäß Anspruch 12.

Wir oben erwähnt, kann durch Positionierung der Luftspalte und/oder Veränderung der Abmessungen der Abschirmbleche die Messempfindlichkeit bzw. der Messbereich der Anordnung zum potentialfreien Messen von Strömen umgestellt bzw. verändert werden. Eine zusätzliche, besonders praktikable Möglichkeit zur Einstellung des Messbereichs besteht darin, dass gemäß Anspruch 13 wenigstens ein weichmagnetisches Einlegeteil, welches als Einlegestift bzw. Einlegestreifen ausgebildet ist, innerhalb der bei den Abschirmbleche angeordnet ist, um das magnetische Differenzfeld in der wirksamen Sensorebene zu beeinflussen.

Hierzu kann das wenigstens eine Einlegeteil zwischen der wirksamen Sensorebene und den Primärleitern gemäß Anspruch 14 angeordnet sein. Insbesondere können zwei Primärleiter, die außerhalb des magnetfeldempfindlichen Bereichs des Differenzfeldsensors angeordnet sind, das zur Strommessung maßgebliche Magnetfeld im Vergleich zu einer Anordnung ohne Einlegeteile schwächen. Ist hingegen wenigstens ein Einlegeteil an dem magnetfeldempfindlichen Bereich des Differenzfeldsensors, zwischen diesem und den beiden Primärleitern angeordnet, so wird die Messempfindlichkeit erhöht. Damit kann eine Basisanordnung, die den Differenzfeldsensor und die Primärleiter innerhalb der Abschirmbleche umfasst, durch einfach zu handhabende zusätzliche Einlegeteile an gewünschte unterschiedliche Messbereiche angepasst werden, so z.B. für Messbereiche von 50 bis 2000 A. Zusätzlich zu der Positionierung des Einlegeteils bzw. der Einlegeteile ist in der Regel die Lage der Luftspalte zu modifizieren. Hierzu sind die Luftspalte gemäß Anspruch 18 einstellbar.

Typische Varianten der Positionierung der Einlegeteile sind in den Ansprüchen 15 bis 17 angegeben.

Generell ist bei einer Anordnung wenigstens eines Einlegeteils entweder zwischen der wirksamen Sensorebene und den Primärleitern oder zwischen der wirksamen Sensorebene und dem am nächsten benachbarten Abschirmblech die Wirkung des wenigstens einen Einlegeteils auf die Messempfindlichkeit bzw. den Messbereich am stärksten ausgeprägt.

Mit dem wenigstens einen Einlegeteil kann gegebenenfalls in Verbindung mit einer Einstellung der Luftspalte bei ansonsten beibehaltenem Grundaufbau der Anordnung der Abschirmbleche, der Primärleiter und des Differenzfeldsensors in der wirksamen Sensorebene ein Messbereich von beispielsweise zwischen 50 bis 2000 A eingestellt werden.

Ausführungsbeispiele der Anordnung zum potentialfreien Messen von Strömen werden nachfolgend anhand von fünf Figuren erläutert, woraus sich weitere Einzelheiten insbesondere hinsichtlich der räumlich-geometrischen Anordnung der Komponenten der Anordnung ergeben. Es zeigen:
- Fig. 1: eine Grundanordnung in einem Querschnitt,
- Fig. 2: eine modifizierte Anordnung, ebenfalls in einem Querschnitt,
- Fig. 3: eine zweite modifizierte Anordnung mit Einlegeteilen, ebenfalls in einem Querschnitt, und
- Fig. 4: eine dritte modifizierte Anordnung mit einem Einlegeteil in einem Querschnitt und
- Fig. 5: eine vierte modifizierte Anordnung ohne Einlegeteil in einem Querschnitt.

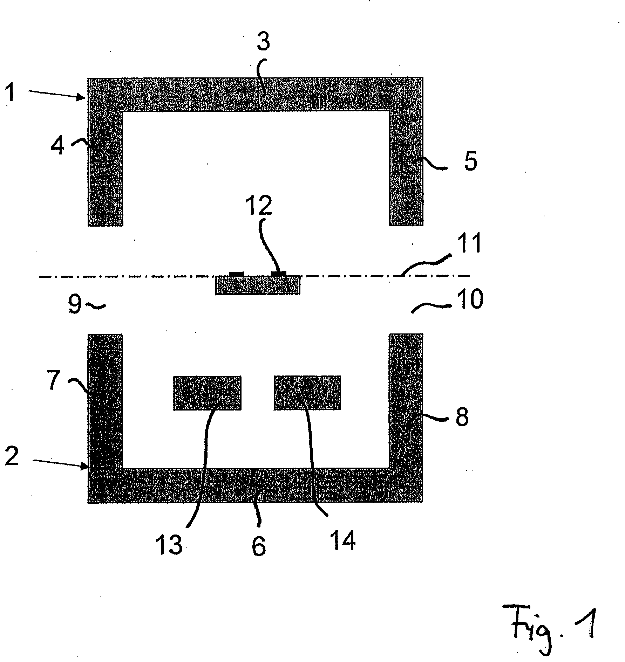

In der Grundanordnung gemäß Fig. 1 sind ein erstes Abschirmblech 1 und ein zweites Abschirmblech 2 aus hochpermeablem Material annähernd U-förmig gebogen. Demgemäß stehen von einem annähernd ebenen Steg 3 des ersten Abschirmblechs 1 zwei Schenkel 4, 5 ab und von einem in Wesentlichen planen Steg 6 des zweiten Abschirmblechs 2 zwei Schenkel 7 und 8. Die beiden Abschirmbleche 1, 2 sind so zueinander angeordnet, dass ihre Schenkel 4, 5 bzw. 7, 8 aufeinander gerichtet sind, d.h. miteinander fluchten, und zwar unter Freilassung je eines Luftspalts 9 bzw. 10. Die Anordnung der beiden Abschirmbleche 1, 2 ist symmetrisch zu einer wirksamen Sensorebene 11, in der eine wirksame Schicht eines Differenzfeldsensors 12 liegt. Der Differenzfeldsensor 12 kann durch einen isolierenden Halter, der nicht dargestellt ist, gegenüber zwei Primärleitern 13, 14 potentialfrei fixiert werden.

Die beiden Primärleiter 13, 14 können, wie im einzelnen in Fig. 1 nicht dargestellt, Schenkel einer im Wesentlichen U-förmigen Leitereinheit sein, die in Längsrichtung (d.h. senkrecht zur Zeichnungsebene) parallel zu den Abschirmblechen 2, 3 und der wirksamen Sensorebene 11 verlaufen. Die Ausdehnung dieser Schenkel in Längsrichtung und die Erstreckung der Schenkel 4, 5, 7, 8 der Abschirmbleche 1, 2, ebenfalls in Längsrichtung, ist dabei im Wesentlichen identisch. Somit werden die Schenkel bzw. Primärleiter 13, 14 zwischen den Abschirmblechen 1, 2 eingeschlossen. Der Differenzfeldsensor erstreckt sich innerhalb dieser Anordnung in Längsrichtung höchstens so weit wie die Schenkel 4, 5, 7, 8 der Abschirmbleche 1, 2.

Bei dieser symmetrischen Anordnung der Abschirmbleche 1 , 2 ist der Raum zwischen den Schenkeln 7, 8 des unteren Abschirmblechs 2 durch Aufnahme der Primärleiter 13, 14 zwischen den Schenkeln 7, 8 genutzt, wogegen das Innere des oberen Abschirmblechs 1 zwischen den Schenkeln 4, 5 frei bleibt, also insofern nicht zur Unterbringung von Komponenten der Anordnung dient.

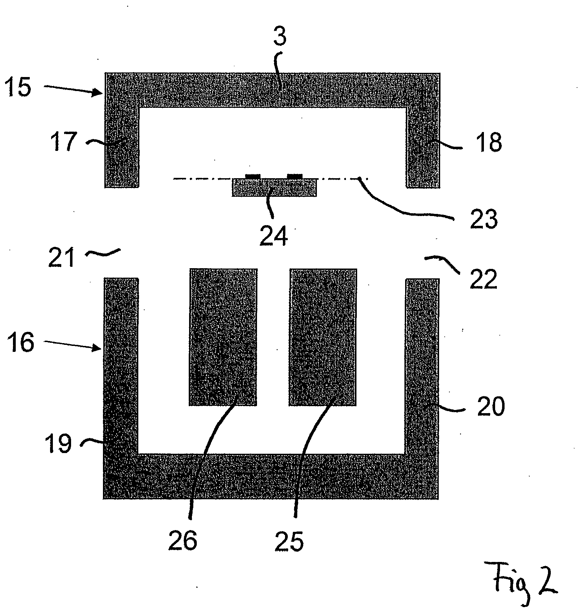

Eine erste modifizierte und damit platzoptimierte Anordnung ist in Fig. 2 gezeigt. Sie unterscheidet sich von der symmetrischen Anordnung gemäß Fig.1 dadurch, dass ein erstes Abschirmblech 15 und ein zweites Abschirmblech 16 unterschiedlich ausgebildet sind, so dass Schenkel 17, 18 des ersten Abschirmblechs zwar untereinander gleich, jedoch kürzer als Schenkel 19, 20 des zweiten Abschirmblechs 16 sind, wobei die Länge der beiden Schenkel 19, 20 gleich ist. Da die fluchtende Anordnung der Schenkel 17, 18 mit den Schenkeln 19, 20, die grundsätzlich wie in der Grundanordnung nach Fig. 1 positioniert sind, wirkt sich dies dahingehend aus, dass Luftspalte 21, 22 zwischen den Schenkeln 17, 19 bzw. 18, 20 in der Anordnung relativ höher liegen als in der Anordnung nach Fig. 1. Desgleichen ist die wirksame Sensorebene 23 des Differenzfeldsensors 24 nach oben versetzt.

Sowohl in der Ausführungsform gemäß Fig. 1 als auch in der nach Fig. 2 befindet sich die Sensorebene außerhalb der Schenkel 7, 8 bzw. 19, 20 des zweiten, unteren Abschirmblechs 2 bzw. 16. Die Schenkel 19, 20 schließen wiederum zwei Primärleiter 25, 26 ein, die über diese Schenkel hinausragen können.

Die beiden Primärleiter 25, 26 können wiederum in Form einer im Wesentlichen U-förmigen Leitereinheit realisiert sein.

Grundsätzlich können die beiden Primärleiter in sämtlichen gezeigten Ausführungsformen der Anordnung aber auch getrennte Hin- und Rückleiter eines elektrischen Verbrauchers sein.

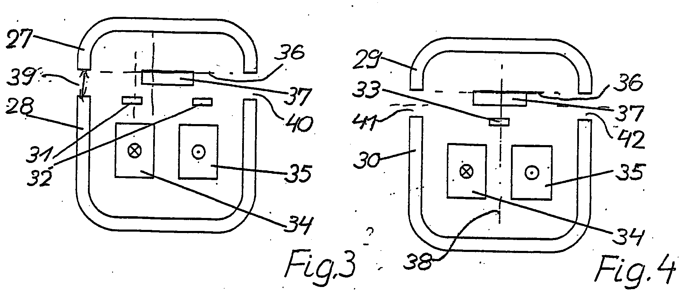

In den Ausführungsformen gemäß den Figuren 3 und 4 sind Beispiele der Positionierung von weichmagnetischen Einlegeteilen in dem von zwei Abschirmblechen 27, 28 in Fig. 3 bzw. 29, 30 in Fig. 4 umschlossenen Räumen von Anordnungen zum potentialfreien Messen von Strömen dargestellt. Die Einlegeteile sind mit 31 -33 bezeichnet. Sie erstrecken sich jeweils in Längsrichtung der Anordnung senkrecht zur Zeichnungsebene im Wesentlichen in gleicher Länge wie die Abschirmbleche 27-30.

Mehr im Einzelnen ist in der Ausführungsform gemäß Fig. 3 jeweils ein Einlegeteil 31 bzw. 32 zwischen einem der beiden Primärleiter 34, 35 und der wirksamen Sensorebene 36 eines Differenzfeldsensors 37 angeordnet.

In der Ausführungsform gemäß Fig. 4 ist hingegen nur das eine Einlegeteil 33 symmetrisch zu einer in Fig. 4 vertikalen Mittelebene 38 positioniert.

In beiden Ausführungsformen nach den Fig. 3 und 4 kann durch die Einlegeteile 31-33 die Messempfindlichkeit bzw. der Messbereich eingestellt werden, wobei weiterhin regelmäßig die Position der Luftspalte 39, 40 bzw. 41, 42 eingestellt wird.

Die Ausführungsform gemäß Fig. 3 führt zu einer Abschwächung des magnetischen Differenzfelds bzw. Feldgradienten in der wirksamen Sensorebene 36, die Ausführungsform gemäß Fig. 4 hingegen zu einer Verstärkung des magnetischen Differenzfelds bzw. Feldgradienten, wodurch die Messempfindlichkeit erhöht und der Messbereich verringert wird.

Die Einlegeteile können insbesondere aus Mu-Metall bestehen.

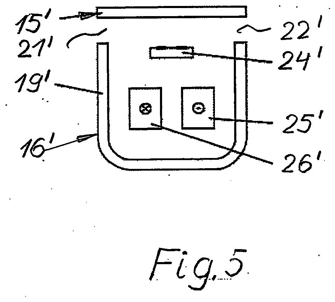

Die in Fig. 5 dargestellte vierte modifizierte, vereinfachte Anordnung ist wie z.B. die erste modifizierte Anordnung zu einer in der Zeichnung nicht dargestellten waagerechten Ebene, insbesondere der wirksamen Sensorebene, unsymmetrisch, und zwar noch weitgehender unsymmetrisch als die modifizierte Anordnung gemäß Figur 2, da nur das zweite Abschirmblech 16' mit zwei Schenkeln 1 9', 20' ausgebildet ist. Hingegen ist das erste Abschirmblech 15' fertigungsgünstig nur plan quasi als Steg ohne Schenkel ausgebildet. Luftspalte 21 ', 22' sind in dieser Anordnung zwischen je einem der Schenkel 19', 20' des zweiten Abschirmblechs 16' einerseits und dem ersten Abschirmblech 15' andererseits ausgebildet, sie befinden sich also an den freien Enden der Schenkel 19', 20'.

Die Schenkel 1 9', 20' schließen auch in dieser Anordnung zwei zueinander parallele Primärleiter 25', 26' ein, und zwar so, dass über den Primärleitern 25', 26' Raum für den Differenzfeldsensor 24' vorhanden bleibt. Die in Figur 5 nicht eingezeichnete wirksame Sensorebene liegt hier geschützt tiefer als die Enden der Schenkel 19', 20'.

Zu der weiter oben beschriebenen Einstellung des Messbereichs kann auch die Ausführungsform gemäß Fig. 5 mit einem Einlegeteil oder zwei Einlegeteilen ausgestattet werden.

### Bezugszeichenliste

- 1: 1. Abschirmblech
- 2: 2. Abschirmblech
- 3: Steg
- 4: Schenkel
- 5: Schenkel
- 6: Steg
- 7: Schenkel
- 8: Schenkel
- 9: Luftspalt
- 10: Luftspalt
- 11: wirksame Sensorebene
- 12: Differenzfeldsensor
- 13: Primärleiter
- 14: Primärleiter
- 15, 15': 1. Abschirmblech
- 16, 16': 2. Abschirmblech
- 17: Schenkel
- 18: Schenkel
- 19, 19': Schenkel
- 20, 20': Schenkel
- 21, 21': Luftspalt
- 22, 22': Luftspalt
- 23: wirksame Sensorebene
- 24, 24': Differenzfeldsensor
- 25, 25': Primärleiter
- 26, 26': Primärleiter
- 27: 1. Abschirmblech
- 28: 2. Abschirmblech
- 29: 1. Abschirmblech
- 30: 2. Abschirmblech
- 31: Einlegeteil
- 32: Einlegeteil
- 33: Einlegeteil
- 34: Primärleiter
- 35: Primärleiter
- 36: wirksame Sensorebene
- 37: Differenzfeldsensor
- 38: vertikale Mittelebene
- 39: Luftspalt
- 40: Luftspalt
- 41: Luftspalt
- 42: Luftspalt

## Patentansprüche

1. Anordnung zum potentialfreien Messen von Strömen, die in zwei im Wesentlichen parallel angeordneten Primärleitern (13, 14; 25, 26; 25', 26'; 34, 35) in zueinander entgegengesetzter Richtung fließen, durch Erfassen des magnetischen Differenzfelds mittels eines Differenzfeldsensors (12, 24, 24',37), wobei zur Herabsetzung von Messfehlern die Primärleiter (13, 14; 25, 26; 25', 26'; 34, 35) und der Differenzfeldsensor (12, 24, 24', 37) zwischen zwei Metallteilen angeordnet sind, **dadurch gekennzeichnet,**
**dass** die beiden Metallteile als Abschirmbleche (1, 2; 15, 16; 15', 16'; 27- 30), aus hochpermeablem Material mit jeweils einem Steg (3 bzw. 6) ausgebildet sind, dass sich die Stege (3, 6) beidseitig der Anordnung der Primärleiter (13, 14; 25, 26; 25', 26'; 34, 35) in deren Richtung parallel zu der Anordnung der Primärleiter (13, 14; 25, 26; 25', 26'; 34, 35) erstrecken, dass wenigstens eines der Abschirmbleche (1, 2; 15, 16; 15', 16'; 27-30) in Querschnittsebenen U-förmig mit jeweils einem Paar Schenkeln (4, 5; 7, 8; 17-20; 19', 20') geformt ist, die sich in einer Längsrichtung rechtwinklig zu den U-förmigen Querschnittsebenen erstrecken, dass die beiden Abschirmbleche (1, 2; 15, 16; 15', 16'; 27-30) so zueinander angeordnet sind, dass das wenigstens eine Schenkelpaar (4, 5; 7, 8; 17-20; 19', 20') eines der beiden Abschirmbleche (1, 2; 15, 16; 15', 16'; 27-30) unter Freilassung je eines Luftspalts (9, 10; 21, 22; 21', 22'; 39, 40) an einem der beiden Schenkel (4, 5; 7, 8; 17-20; 19', 20') auf das andere der beiden Abschirmbleche (1, 2; 15, 16; 15', 16'; 27-30) ausgerichtet ist, und
**dass** sich die Primärleiter (13, 14; 25, 26; 25', 26'; 34, 35) in Längsrichtung der Schenkel (4, 5; 7, 8; 17-20; 19', 20') erstrecken.

2. Anordnung nach Anspruch 1, **dadurch gekennzeichnet,**
**dass** beide Abschirmbleche (1, 2; 15, 16; 27-30) mit jeweils einem Paar Schenkeln (4, 5; 7, 8; 17-20) geformt sind zwischen denen sich jeweils einer der Stege (3,6) befindet, und dass die Abschirmbleche (1, 2; 15, 16; 27-30) so zueinander angeordnet sind, dass die beiden Schenkelpaare (4, 5; 7, 8; 17-20) der Abschirmbleche (1, 2; 15, 16; 27-30) unter Freilassung je eines Luftspalts (9, 1 0; 21, 22; 39, 40) zwischen zwei der Schenkel (4, 5; 7, 8; 17-20) aufeinander ausgerichtet sind.

3. Anordnung nach Anspruch 1 oder 2, **dadurch gekennzeichnet,**
**dass** die Primärleiter (13, 14; 25, 26; 25', 26'; 34, 35) zwischen den Schenkeln (4, 5; 7, 8; 17-20; 19', 20') eines der beiden Abschirmbleche (1, 2; 15, 16; 15', 16'; 27-30) angeordnet sind.

4. Anordnung nach Anspruch 1 oder 2, **dadurch gekennzeichnet,**
**dass** die wirksame Sensorebene (11, 23, 36) außerhalb der Schenkel (7, 8, 19-20) des Abschirmblechs (2, 16, 28, 30) liegt, zwischen denen die Primärleiter (13, 14, 25, 26, 35, 36) angeordnet sind.

5. Anordnung nach den Ansprüchen 1 - 4, **dadurch gekennzeichnet,**
**dass** die Schenkel (4, 5; 7, 8; 17-20) der beiden Abschirmbleche (1, 2, 15, 16, 27-30) gleich lang sind und
**dass** die beiden Abschirmbleche (1, 2; 15, 16; 27-30) symmetrisch zu einer wirksamen Sensorebene (11, 23, 36) angeordnet sind.

6. Anordnung nach den Ansprüchen 1 - 4, **dadurch gekennzeichnet,**
**dass** die Schenkel (17, 18; 19, 20) jeweils eines der Abschirmbleche (15, 16) gleich lang sind,
**dass** die Schenkelpaare (4, 5; 19, 20) der Abschirmbleche (15, 16) unterschiedliche Länge aufweisen und
**dass** die Primärleiter (25, 26) zwischen den längeren Schenkeln (19, 20) eines der beiden Abschirmbleche (15, 16) angeordnet sind.

7. Anordnung nach einem der Ansprüche 1 - 6, **dadurch gekennzeichnet,**
**dass** sich die Abschirmbleche (1, 2; 15, 16; 15', 16'; 27-30) in Längsrichtung ihrer Schenkel (4, 5; 7, 8; 17-20; 19', 20') über den Differenzfeldsensor (12, 24, 24', 36) erstrecken.

8. Anordnung nach einem der vorangehenden Ansprüche, **dadurch gekennzeichnet,**
**dass** die beiden parallelen Primärleiter (13, 14; 25, 26; 25', 26'; 34, 35) Schenkel einer U-förmigen Leitereinheit sind.

9. Anordnung nach einem der Ansprüche 1 - 7, **dadurch gekennzeichnet,**
**dass** die beiden parallelen Primärleiter (13, 14; 25, 26; 25', 26'; 35, 36) Hin- und Rückleiter eines elektrischen Verbrauchers sind.

10. Anordnung nach Anspruch 8, **dadurch gekennzeichnet,**
**dass** sich die Abschirmbleche (1, 2; 15, 16; 15', 16'; 27-30) in Längsrichtung ihrer Schenkel (4, 5, 7, 17-20) über die Länge der Schenkel (4, 5; 7, 8; 17-20; 19', 20') der U-förmigen Leitereinheit in Stromrichtung erstrecken.

11. Anordnung nach einem der vorangehenden Ansprüche, **dadurch gekennzeichnet,**
**dass** die Abschirmbleche(1, 2; 15, 16; 15', 16'; 27-30) aus Mu-Metall bestehen.

12. Anordnung nach einem der Ansprüche 1 - 10, **dadurch gekennzeichnet, dass** die Abschirmbleche Elektrobleche sind.

13. Anordnung nach einem der vorangegangenen Ansprüche, **dadurch gekennzeichnet,**
**dass** zur Einstellung des magnetischen Differenzfelds in der wirksamen Sensorebene (11, 23, 36) wenigstens ein weichmagnetisches Einlegeteil (31-33) dient, das innerhalb der beiden Abschirmbleche (1, 2; 15, 16; 27-30) angeordnet ist.

14. Anordnung nach Anspruch 13, **dadurch gekennzeichnet,**
**dass** das wenigstens ein Einlegeteil (31-33) zwischen der wirksamen Sensorebene (11, 23, 36) und den Primärleitern (13, 14; 25, 26; 34, 35) angeordnet ist.

15. Anordnung nach Anspruch 14, **dadurch gekennzeichnet,**
**dass** zwischen jedem der Primärleiter (34, 35) und der wirksamen Sensorebene (36) je ein Einlegeteil (31 bzw. 32) angeordnet ist.

16. Anordnung nach Anspruch 14, **dadurch gekennzeichnet,**
**dass** zwischen beiden Primärleitern (34, 35) und der wirksame Sensorebene (36) nur ein Einlegeteil (33) symmetrisch zu einer Mittenebene (38) zwischen den Primärleitern (34, 35) angeordnet ist.

17. Anordnung nach Anspruch 14, **dadurch gekennzeichnet,**
**dass** das wenigstens eine Einlegeteil zwischen der aktiven Sensorebene und dem am nächsten benachbarten Abschirmblech angeordnet ist.

18. Anordnung nach einem der vorangehenden Ansprüche, **dadurch gekennzeichnet,**
**dass** die Luftspalte (39-42) an beziehungsweise zwischen den Schenkeln der Abschirmbleche (27, 28; 29, 30) einstellbar sind.

## Claims

1. Arrangement for potential-free measuring of currents flowing in opposite directions to one another in two primary conductors (13, 14; 25, 26; 25', 26'; 34, 35) arranged substantially parallel by recording the magnetic differential field by means of a differential field sensor (12, 24, 24', 37), where the primary conductors (13, 14; 25, 26; 25', 26'; 34, 35) and the differential field sensor (12, 24, 24', 37) are arranged between two metal parts in order to reduce measurement errors , **characterized in**
**that** the two metal parts are designed as shielding plates (1, 2; 15, 16; 15', 16'; 27- 30), of highly permeable material with one web (3 and 6) respectively, that the webs (3, 6) extend on both sides of the arrangement of the primary conductors (13, 14; 25, 26; 25', 26'; 34, 35) in their direction parallel to the arrangement of the primary conductors (13, 14; 25, 26; 25', 26'; 34, 35), that at least one of the shielding plates (1, 2; 15, 16; 15', 16'; 27-30) is shaped in cross-sectional planes in a U-shape with one pair of legs (4, 5; 7, 8; 17-20; 19', 20') respectively extending in a longitudinal direction at right angles to the U-shaped cross-sectional planes, that the two shielding plates (1, 2; 15, 16; 15', 16'; 27-30) are arranged relative to one another such that the at least one pair of legs (4, 5; 7, 8; 17-20; 19', 20') of one of the two shielding plates (1, 2; 15, 16; 15', 16'; 27-30) is aligned with the other of the two shielding plates (1, 2; 15, 16; 15', 16'; 27-30) while leaving an air gap (9, 10; 21, 22; 21', 22'; 39, 40) respectively at one of the two legs (4, 5; 7, 8; 17-20; 19', 20'), and
**that** the primary conductors (13, 14; 25, 26; 25', 26'; 34, 35) extend in the longitudinal direction of the legs (4, 5; 7, 8; 17-20; 19', 20').

2. Arrangement according to claim 1, **characterized in**
**that** the two shielding plates (1, 2; 15, 16; 27-30) are shaped with a pair of legs (4, 5; 7, 8; 17-20) respectively between which one of the webs (3, 6) respectively is located, and that the shielding plates (1, 2; 15, 16; 27-30) are arranged relative to one another such that the two pairs of legs (4, 5; 7, 8; 17-20) of the shielding plates (1, 2; 15, 16; 27-30) are aligned with one another while leaving an air gap (9, 10; 21, 22; 39, 40) respectively between two of the legs (4, 5; 7, 8; 17-20).

3. Arrangement according to claim 1 or 2, **characterized in**
**that** the primary conductors (13, 14; 25, 26; 25', 26'; 34, 35) are arranged between the legs (4, 5; 7, 8; 17-20; 19', 20') of one of the two shielding plates (1, 2; 15, 16; 15', 16'; 27-30).

4. Arrangement according to claim 1 or 2, **characterized in**
**that** the effective sensor plane (11, 23, 36) is outside the legs (7, 8, 19-20) of the shielding plate (2, 16, 28, 30) between which the primary conductors (13, 14, 25, 26, 35, 36) are arranged.

5. Arrangement according to claims 1 - 4, **characterized in**
**that** the legs (4, 5; 7, 8; 17-20) of the two shielding plates (1, 2, 15, 16, 27-30) are of the same length and
**that** the two shielding plates (1, 2; 15, 16; 27-30) are arranged symmetrical to an effective sensor plane (11, 23, 36).

6. Arrangement according to claims 1 - 4, **characterized in**
**that** the legs (17, 18; 19, 20) of the shielding plates (15, 16) respectively are of the same length,
**that** the pairs of legs (4, 5; 19, 20) of the shielding plates (15, 16) have different lengths and
**that** the primary conductors (25, 26) are arranged between the longer legs (19, 20) of one of the two shielding plates (15, 16).

7. Arrangement according to one of claims 1 - 6, **characterized in**
**that** the shielding plates (1, 2; 15, 16; 15', 16'; 27-30) extend in the longitudinal direction of their legs (4, 5; 7, 8; 17-20; 19', 20') over the differential field sensor (12, 24, 24', 36).

8. Arrangement according to one of the preceding claims, **characterized in**
**that** the two parallel primary conductors (13, 14; 25, 26; 25', 26'; 34, 35) are legs of a U-shaped conductor unit.

9. Arrangement according to one of claims 1 - 7, **characterized in that** the two parallel primary conductors (13, 14; 25, 26; 25', 26'; 35, 36) are supply and return conductors of an electrical load.

10. Arrangement according to claim 8, **characterized in**
**that** the shielding plates (1, 2; 15, 16; 15', 16'; 27-30) extend in the longitudinal direction of their legs (4, 5, 7, 17-20) over the length of the legs (4, 5; 7, 8; 17-20; 19', 20') of the U-shaped conductor unit in the current direction.

11. Arrangement according to one of the preceding claims, **characterized in**
**that** the shielding plates (1, 2; 15, 16; 15', 16'; 27-30) consist of mu-metal.

12. Arrangement according to one of claims 1 - 10, **characterized in**
**that** the shielding plates are electrical sheets.

13. Arrangement according to one of the preceding claims, **characterized in**
**that** at least one magnetically soft insert part (31-33) is used to adjust the magnetic differential field in the effective sensor plane (11, 23, 36) and is arranged inside the two shielding plates (1, 2; 15, 16; 27-30).

14. Arrangement according to claim 13, **characterized in**
**that** the at least one insert part (31-33) is arranged between the effective sensor plane (11, 23, 36) and the primary conductors (13, 14; 25, 26; 34, 35).

15. Arrangement according to claim 14, **characterized in**
**that** an insert part (31, 32) is arranged between each of the primary conductors (34, 35) respectively and the effective sensor plane (36).

16. Arrangement according to claim 14, **characterized in**
**that** between the two primary conductors (34, 35) and the effective sensor plane (36), only one insert part (33) is arranged symmetrical to a central plane (38) between the primary conductors (34, 35).

17. Arrangement according to claim 14, **characterized in**
**that** the at least one insert part is arranged between the active sensor plane and the nearest adjacent shielding plate.

18. Arrangement according to one of the preceding claims, **characterized in**
**that** the air gaps (39-42) at or between the legs of the shielding plates (27, 28; 29, 30) are adjustable.

## Revendications

1. Disposition pour la mesure exempte de potentiel de courants qui circulent dans deux conducteurs primaires (13, 14 ; 25, 26 ; 25', 26' ; 34, 35) disposés essentiellement parallèlement, dans des sens opposés l'un par rapport à l'autre, par le biais de l'acquisition du champ magnétique différentiel au moyen d'un capteur de champ différentiel (12, 24, 24',37), sachant que pour réduire les erreurs de mesure, les conducteurs primaires (13, 14 ; 25, 26 ; 25', 26' ; 34, 35) et le capteur de champ différentiel (12, 24, 24', 37) sont disposés entre deux pièces métalliques, **caractérisée en ce**
**que** les deux pièces métalliques sont conçues sous forme de tôles de blindage (1, 2 ; 15, 16 ; 15', 16' ; 27- 30) en matériau ultraperméable avec respectivement une nervure (3 ou 6), que les nervures (3, 6) des deux côtés de la disposition des conducteurs primaires (13, 14 ; 25, 26 ; 25', 26' ; 34, 35) s'étendent dans leur direction, parallèlement à la disposition des conducteurs primaires (13, 14 ; 25, 26 ; 25', 26' ; 34, 35), qu'au moins une des tôles de blindage (1, 2 ; 15, 16 ; 15', 16' ; 27-30) est en forme de U dans des plans de coupe transversale avec respectivement une paire de branches (4, 5 ; 7, 8 ; 17-20 ; 19', 20') qui s'étendent dans un sens longitudinal à angle droit des plans de coupe transversale en forme de U, que les deux tôles de blindage (1, 2 ; 15, 16 ; 15', 16' ; 27-30) sont disposées l'une par rapport à l'autre de sorte que l'au moins une paire de branches (4, 5 ; 7, 8 ; 17-20 ; 19', 20') d'une des deux tôles de blindage (1, 2 ; 15, 16 ; 15', 16' ; 27-30) est alignée, au niveau d'une des deux branches (4, 5 ; 7, 8 ; 17-20 ; 19', 20') sur l'autre des deux tôles de blindage (1, 2 ; 15, 16 ; 15', 16' ; 27-30), en laissant respectivement un intervalle d'air (9, 10 ; 21, 22 ; 21', 22' ; 39, 40) libre, et
**que** les conducteurs primaires (13, 14 ; 25, 26 ; 25', 26' ; 34, 35) s'étendent dans le sens longitudinal des branches (4, 5 ; 7, 8 ; 17-20 ; 19', 20').

2. Disposition selon la revendication 1, **caractérisée en ce**
**que** les deux tôles de blindage (1, 2 ; 15, 16 ; 27-30) sont formées avec respectivement une paire de branches (4, 5 ; 7, 8 ; 17-20) entre lesquelles se trouve respectivement une des nervures (3, 6) et que les tôles de blindage (1, 2 ; 15, 16 ; 27-30) sont disposées de telle sorte que les deux paires de branches (4, 5 ; 7, 8 ; 17-20) des tôles de blindage (1, 2 ; 15, 16 ; 27-30) sont alignées, en laissant respectivement un intervalle d'air (9, 10 ; 21, 22 ; 39, 40) entre deux des branches (4, 5 ; 7, 8 ; 17-20).

3. Disposition selon la revendication 1 ou 2, **caractérisée en ce**
**que** les conducteurs primaires (13, 14 ; 25, 26 ; 25', 26' ; 34, 35) sont disposés entre les branches (4, 5 ; 7, 8 ; 17-20 ; 19', 20') d'une des deux tôles de blindage (1, 2 ; 15, 16 ; 15', 16' ; 27-30).

4. Disposition selon la revendication 1 ou 2, **caractérisée en ce**
**que** le plan actif du capteur (11, 23, 36) se situe à l'extérieur des branches (7, 8, 19-20) de la tôle de blindage (2, 16, 28, 30) entre lesquelles sont disposés les conducteurs primaires (13, 14, 25, 26, 35, 36).

5. Disposition selon les revendications 1 à 4, **caractérisée en ce**
**que** les branches (4, 5 ; 7, 8 ; 17-20) des deux tôles de blindage (1, 2, 15, 16, 27-30) sont de même longueur et
**que** les deux tôles de blindage (1, 2 ; 15, 16 ; 27-30) sont disposées symétriquement à un plan actif du capteur (11, 23, 36).

6. Disposition selon les revendications 1 à 4, **caractérisée en ce**
**que** les branches (17, 18 ; 19, 20) d'une même tôle parmi les deux tôles de blindage (15, 16) sont de même longueur,
**que** les paires de branches (4, 5 ; 19, 20) des tôles de blindage (15, 16) présentent des longueurs différentes et
**que** les conducteurs primaires (25, 26) sont disposés entre les branches les plus longues (19, 20) d'une des deux tôles de blindage (15, 16).

7. Disposition selon une des revendications 1 à 6, **caractérisée en ce**
**que** les tôles de blindage (1, 2 ; 15, 16 ; 15', 16' ; 27-30) s'étendent dans le sens longitudinal de leurs branches (4, 5 ; 7, 8 ; 17-20 ; 19', 20') par-dessus le capteur de champ différentiel (12, 24, 24', 36).

8. Disposition selon une des revendications précédentes, **caractérisée en ce**
**que** les deux conducteurs primaires parallèles (13, 14 ; 25, 26 ; 25', 26' ; 34, 35) sont des branches d'un ensemble conducteur en forme de U.

9. Disposition selon une des revendications 1 à 7, **caractérisée en ce que** les deux conducteurs primaires parallèles (13, 14 ; 25, 26 ; 25', 26' ; 35, 36) sont des conducteurs d'aller et de retour d'un récepteur électrique.

10. Disposition selon la revendication 8, **caractérisée en ce**
**que** les tôles de blindage (1, 2 ; 15, 16 ; 15', 16' ; 27-30) s'étendent dans le sens longitudinal de leurs branches (4, 5 7, 17-20) sur la longueur des branches (4, 5 ; 7, 8 ; 17-20 ; 19', 20') de l'ensemble conducteur en forme de U dans le sens du courant.

11. Disposition selon une des revendications précédentes, **caractérisée en ce**
**que** les tôles de blindage (1, 2 ; 15, 16 ; 15', 16' ; 27-30) sont en mu-métal.

12. Disposition selon une des revendications 1 à 10, **caractérisée en ce**
**que** les tôles de blindage sont des tôles électriques.

13. Disposition selon une des revendications précédentes, **caractérisée en ce**
**qu'**au moins un insert (31-33) magnétique doux, disposé à l'intérieur des deux tôles de blindage (1, 2 ; 15, 16 ; 27-30) sert au réglage du champ magnétique différentiel dans le plan actif du capteur (11, 23, 36).

14. Disposition selon la revendication 13, **caractérisée en ce**
**qu'**au moins un insert (31-33) est disposé entre le plan actif du capteur (11, 23, 36) et les conducteurs primaires (13, 14 ; 25, 26 ; 34, 35).

15. Disposition selon la revendication 14, **caractérisée en ce**
**qu'**un insert (31 ou 32) est disposé respectivement entre chacun des conducteurs primaires (34, 35) et le plan actif du capteur (36).

16. Disposition selon la revendication 14, **caractérisée en ce**
**qu'**entre les deux conducteurs primaires (34, 35) et le plan actif du capteur (36) est disposé un seul insert (33) symétriquement au plan médian (38) entre les conducteurs primaires (34, 35).

17. Disposition selon la revendication 14, **caractérisée en ce**
**qu'**au moins un insert est disposé entre le plan actif du capteur et la tôle de blindage voisine la plus proche.

18. Disposition selon une des revendications précédentes, **caractérisée en ce**
**que** les intervalles d'air (39-49) au niveau des ou entre les branches des tôles de blindage (27, 28 ; 29, 30) sont réglables.
